# EUROPEAN PATENT SPECIFICATION

(11) **EP 3 598 583 B1**
(45) Date of publication and mention of the grant of the patent: **22.09.2021**
(21) Application number: 18767910.5
(22) Date of filing: 27.02.2018
(51) Int. Cl.: H05K 5/00, H01R 12/51, H01R 12/55, H01R 12/71

(54) **ELECTRONIC DEVICE HAVING FIXED ELECTRIC CONDUCTIVE PLATE AND FLEXIBLE ELECTRIC CONDUCTIVE PLATE**
ELEKTRONISCHE VORRICHTUNG MIT FESTER ELEKTRISCH LEITENDER PLATTE UND FLEXIBLER ELEKTRISCH LEITENDER PLATTE
DISPOSITIF ÉLECTRONIQUE AYANT UNE PLAQUE CONDUCTRICE ÉLECTRIQUE FIXE ET UNE PLAQUE CONDUCTRICE ÉLECTRIQUE FLEXIBLE

(30) Priority: 14.03.2017 JP 2017048152
(43) Date of publication of application: 22.01.2020
(73) Proprietor: Alps Alpine Co., Ltd., Tokyo 1458501 (JP)
(72) Inventor: KIKUCHI, Shinji, Tokyo 145-8501 (JP); NAKAYAMA, Keisuke, Tokyo 145-8501 (JP); WAGA, Satoshi, Tokyo 145-8501 (JP)
(74) Representative: Schmitt-Nilson Schraud Waibel Wohlfrom Patentanwälte Partnerschaft mbB
(86) International application number: PCT/JP2018/007082
(87) International publication number: WO 2018/168425

(56) References cited:
- WO-A1-2011/158801
- JP-A- H1 032 107
- JP-A- 2001 004 365
- JP-U- H0 199 006
- JP-U- H0 550 701
- US-A- 5 856 774
- US-A- 6 018 992
- US-A1- 2012 289 091

## Description

### Technical Field

The present invention relates to an electronic device in which fixed conductive plates and elastic conductive plates pressed elastically against fixed electrode portions provided on a circuit board or the like on which a physical quantity sensor is mounted are provided in a case.

### Background Art

An invention related to an electronic part in which external terminals (fixed conductive plates) and internal terminals (elastic conductive plates) are provided in a cabinet 1 is described in PTL 1.

In this electronic part, an external terminal 2 fixed in the cabinet 1 is provided, and a flat portion 2a and an opposing portion 2f, which face each other by bending the external terminal 2, are formed. An internal terminal 3, which can be elastically deformed, is attached between the flat portion 2a and opposing portion 2f of the external terminal 2. A flat portion 3a, a first elastic portion 3b bent from the flat portion 3a, and an abutting portion 3c at the top of the first elastic portion 3b are formed integrally with the internal terminal 3. The flat portion 3a is elastically in contact with the flat portion 2a of the external terminal 2, and the abutting portion 3c is elastically in contact with the opposing portion 2f of the external terminal 2. A 180-degree turn-back portion is provided at the top of the flat portion 3a of the internal terminal 3. A second elastic portion 3d extends from the turn-back portion. A contact point 3e at the top of the second elastic portion 3d is elastically in contact with a resistive pattern 4a on the front surface of an insulated substrate 4.

Also, a stopper portion 3f, which is cut from the flat portion 3a and is raised, is formed integrally with the internal terminal 3. This stopper portion 3f is engaged with a concave portion 2b formed in the external terminal 2 or with a concave portion 1t formed in a side wall of the cabinet 1 to prevent the internal terminal 3 from coming off.

### Citation List

### Patent Literature

PTL 1: Japanese Unexamined Patent Application Publication No. 10-32107

### Summary of Invention

### Technical Problem

In the electronic part described in PTL 1, the stopper portion 3f, which is cut from the flat portion 3a of the internal terminal 3 and is raised, is engaged with the concave portion 2b or concave portion 1t to prevent the internal terminal from coming off. However, this engagement between the stopper portion 3f and the concave portion alone cannot adequately prevent the internal terminal 3 from coming off. To increase the coming off prevention effect, it is necessary to form the stopper portion 3f in such a way that it becomes long. As a result, a problem arises in that the internal terminal 3 becomes larger than necessary.

Also, in the electronic part described in PTL 1, the top of the flat portion 3a of the internal terminal 3 is turned back 180 degrees as indicated in Fig. 3 and Fig. 4 in PTL 1. By providing this 180-degree turn-back portion, the position of the base end of the internal terminal 3 extending from the turn-back portion is determined. In this structure, however, when a force is exerted on the second elastic portion 3d, stress concentrates on the 180-degree turn-back portion. This is likely to become a cause of fatigue.

The present invention addresses the above conventional problem with the object of providing an electronic device, having fixed conductive plates and elastic conductive plates, that can increase the effect of preventing the elastic conductive plates from coming off.

Another object of the present invention is to provide an electronic device, having fixed conductive plates and elastic conductive plates, that can determine the position of the base end of an elastic arm portion without forming a 180-degree turn-back portion on the elastic conductive plate and can optimally set an elastic force between an elastically-pressed contact point and a fixed electrode portion.

### Solution to Problem

In an electronic device in which a fixed conductive plate, part of which becomes an external terminal portion, an elastic conductive plate connected to the fixed conductive plate, and a fixed electrode portion that is electrically continuous to the elastic conductive plate are provided in a case, the electronic device, in the present invention, that has a fixed conductive plate and an elastic conductive plate is characterized in that:
a first contact surface and a second contact surface, which are opposite to each other, are provided in the case, at least one of the first contact surface and the second contact surface being the front plate surface of the fixed conductive plate;
as for the elastic conductive plate, a first pressure contact portion, which is elastically pressed against the first contact surface, a second pressure contact portion, which is turned-backed from the first pressure contact portion and is elastically pressed against the second contact surface, a support piece portion, which is bent from the second pressure contact portion and extends beyond the first contact surface, an elastic arm portion, which is bent from the support piece portion and extends toward the fixed electrode portion, and an elastically-pressed contact point, which is provided at the top of the elastic arm portion and is elastically pressed against the fixed electrode portion, are integrally formed from a metal leaf spring material;
at least one of the first pressure contact portion and the second pressure contact portion is in contact with the front plate surface of the fixed conductive plate; and
a restricting support portion positioned on a side opposite to the fixed electrode portion with the elastic conductive plate interposed between the restricting support portion and the fixed electrode portion is provided, the restricting support portion restricting the travel of the support piece portion in a direction away from the fixed electrode portion.

Furthermore, the electronic device, in the present invention, that has the fixed conductive plate and elastic conductive plate is provided with a restricting opposing portion that is opposite to the restricting support portion with the support piece portion interposed between the restricting opposing portion and the restricting support or is in contact with the restricting support portion.

In the electronic device, in the present invention, that has the fixed conductive plate and elastic conductive plate, it is preferable for the restricting support portion and the restricting opposing portion to be opposite to a position close to the boundary portion of the support piece portion with the elastic arm portion.

In the electronic device, in the present invention, that has the fixed conductive plate and elastic conductive plate, an inner wall portion is provided in the case, a plurality of support protrusion portions are provided at the top of the inner wall, and the restricting opposing portion is provided between adjacent support protrusion portions.

In this case, it is preferable that an opposing concave portion be formed in the case, the support protrusion portion being opposite to the opposing concave portion, and that the top of the support protrusion portion be inserted into the opposing concave portion.

### Advantageous Effects of Invention

In the electronic device in the present invention, a first pressure contact portion, a second pressure contact portion, a support piece portion bent from the second pressure contact portion, and an elastic arm portion bent from the support piece portion are formed for an elastic conductive plate. A restricting support portion restricts the travel of the support piece portion in a direction away from a fixed electrode portion. Therefore, it is possible to effectively restrict the elastic conductive plate from coming off a clearance between a first contact surface and a second contact surface.

In the electronic device in the present invention, the restricting support portion and a restricting opposing portion are preferably opposite to both surfaces of the support piece portion at a position close to the boundary portion between the support piece portion and the elastic arm portion. Therefore, it is possible to set the base end (support end) of the elastic arm portion, which is a cantilever beam, in the vicinity of the bending boundary portion between the support piece portion and the elastic arm portion. Since the base end (support end) of the elastic arm portion can be determined, the working lengths of elastic arm portions can be easily made uniform and a pressure contact force between an elastically-pressed contact portion and the fixed electrode portion can be optimally set. In addition, since a 180-degree turn-back portion or the like is not provided for the elastic conductive plate, concentration of stress on the base end (support end) of the elastic arm portion can be mitigated and accumulation of fatigue can thereby be reduced.

### Brief Description of Drawings

[Fig. 1] Fig. 1 is a cross-sectional view indicating an electronic device in an embodiment of the present invention.
[Fig. 2] Fig. 2 is a partially enlarged view of the cross-sectional view of the electronic device in the embodiment indicated in Fig. 1.
[Fig. 3] Fig. 3 indicates the structure of the electronic device in the embodiment indicated in Fig. 1, the drawing being a perspective view including a partial cross-section.
[Fig. 4] Fig. 4 indicates the structure of the electronic device in the embodiment indicated in Fig. 1, the drawing being an exploded perspective view including a partial cross-section of a first case and indicating a second case in a transparent display.
[Fig. 5] Fig. 5 indicates the structure of the electronic device in the embodiment indicated in Fig. 1, the drawing being an exploded perspective view indicating the first case and elastic conductive plates.
[Fig. 6] Fig. 6 is an exploded perspective view indicating fixed conductive plates and elastic conductive plates provided in the electronic device in the embodiment indicated in Fig. 1.

### Description of Embodiments

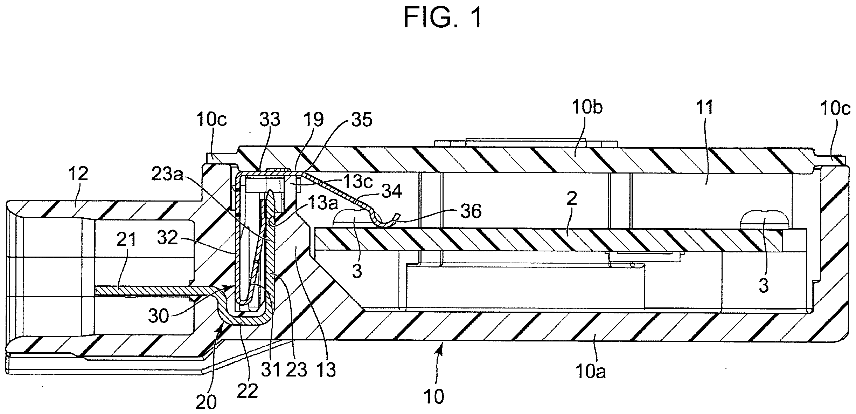

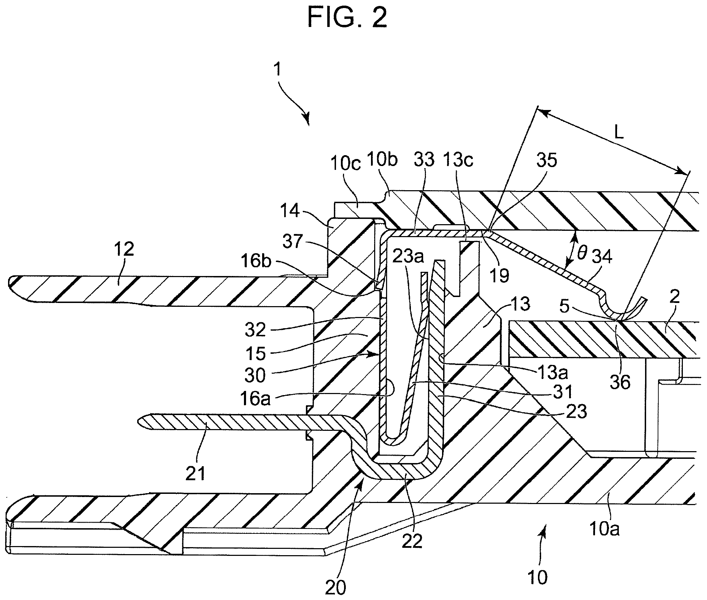

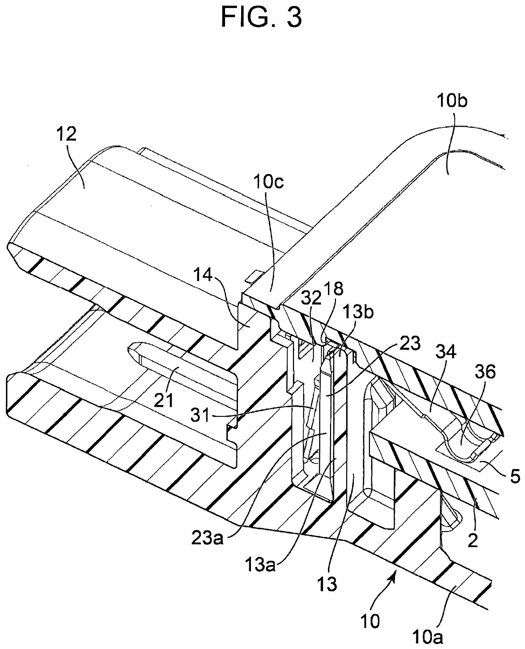

In Fig. 1 and Fig. 2, an electronic device 1 in an embodiment of the present invention is indicated as a cross-sectional view. In each of Fig. 3 to Fig. 5, the electronic device 1 is indicated as a perspective view or exploded perspective view that indicates a partial cross-section.

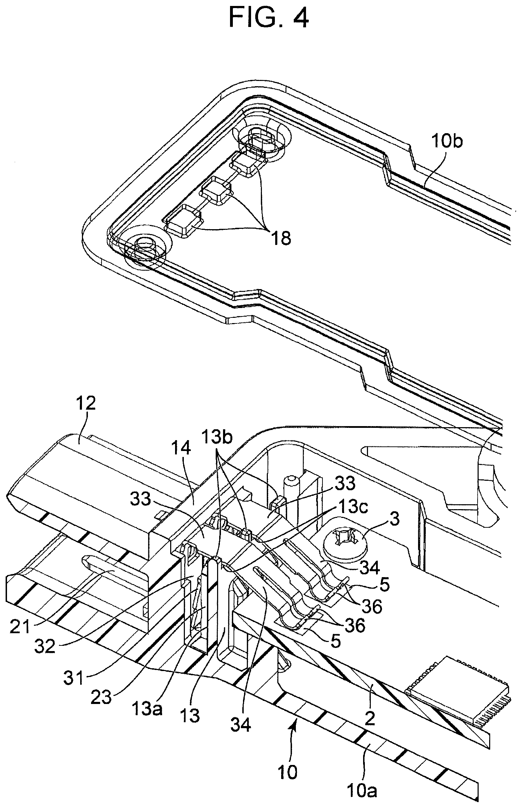

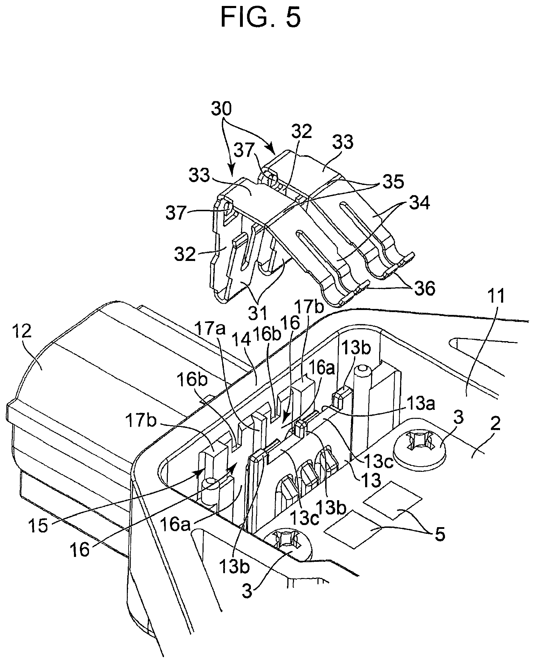

In this electronic device 1, a circuit board 2 is accommodated in internal space 11 in a case (cabinet) 10. As indicated in Fig. 4 and Fig. 5, the circuit board 2 is fixed to the case 10 with fixing screws 3. On the circuit board 2, an acceleration sensor is mounted as a physical quantity sensor. Alternatively, the physical quantity sensor may be a pressure sensor, a humidity sensor, an angular velocity sensor, or the like. The electronic device 1 is for use in a vehicle. The electronic device 1 is attached to, for example, the axle, its support portion, or the like and is used for detection of acceleration exerted on the vehicle body. Therefore, the electronic device 1 is needed to be structured so that even if large acceleration is exerted, a contact failure or the like is not caused in the internal structure.

The case 10 is made of a synthetic resin. The case 10 is structured by combining a first case 10a forming the internal space 11 and a second case 10b, in a cover body structure, that covers the opening portion of the internal space 11. The edge 10c of the second case 10b is bonded and fixed to the opening end of the first case 10a. Alternatively, the edge 10c is fixed by screwing or laser welding. Incidentally, in Fig. 4, the second case 10b is illustrated as being transparent.

As indicated in each of Fig. 1 to Fig. 5, a connector portion 12 in a hollow shape is integrally formed on the left side, in the drawing, of the first case 10a. As indicated in Fig. 1 and Fig. 2, fixed conductive plates 20 are buried in the first case 10a. The first case 10a is injection-molded from a synthetic resin. During this molding, the fixed conductive plates 20 are inserted into a mold and the first case 10a and fixed conductive plates 20 are integrated together by so-called insert-molding. However, the fixed conductive plates 20 may be fixed by, for example, being inserted into the first case 10a that has been already molded.

The fixed conductive plate 20 is formed from a conductive metal plate such as brass. The fixed conductive plate 20 has an external terminal portion 21. The external terminal portion 21 protrudes from the first case 10a into the interior of the connector portion 12. As for the fixed conductive plate 20, as indicated in Fig. 1 and Fig. 2, the base of the external terminal portion 21 and a bent bottom 22, which is bent from the base in the downward direction in the drawings, are buried in the first case 10a.

As indicated in Fig. 4 and Fig. 5, an inner wall portion 13 erected from the bottom side in the drawings toward the internal space 11 is formed integrally with the first case 10a. As indicated in Fig. 1 and Fig. 2, a contact plate portion 23 bent from the bent bottom 22 substantially at right angles is provided for the fixed conductive plate 20. The contact plate portion 23 is placed in tight contact with an opposing inner surface 13a of the inner wall portion 13 and is supported.

As indicated in Fig. 5, a peripheral wall portion 14 continuous to the connector portion 12 is provided for the first case 10a. A peripheral wall support portion 15 opposite to the inner wall portion 13 is formed integrally with an inner wall, facing the internal space 11, of the peripheral wall portion 14. A pair of holding concave portions 16 and 16 extending in the up-and-down direction is formed in the peripheral wall support portion 15. A partitioning rib 17a extending in the up-and-down direction is integrally formed between the two holding concave portions 16 and 16. Partitioning ribs 17b and 17b extending in the up-and-down direction are formed at the side portion of each holding concave portion 16 as well.

The contact plate portion 23 of the fixed conductive plate 20 is indicated in Fig. 2. The front plate surface of the contact plate portion 23, the front plate surface being opposite to the peripheral wall support portion 15, is a first contact surface 23a. As indicated in Fig. 5 as well, the inner front surface of the holding concave portion 16 is a second contact surface 16a. In the internal space 11 of the case 10, the first contact surface 23a and second contact surface 16a are opposite to each other in parallel. In this embodiment, the first contact surface 23a is the front plate surface of the contact plate portion 23 of the fixed conductive plate 20, and the second contact surface 16a is the front surface of a synthetic resin material forming the case 10. Contrary to this embodiment, however, the first contact surface may be the front surface of the inner wall portion 13, and the second contact surface may be the front plate surface of the fixed conductive plate 20 positioned in the holding concave portion 16. Alternatively, both the first contact surface and second contact surface may be the front plate surface of the fixed conductive plate 20.

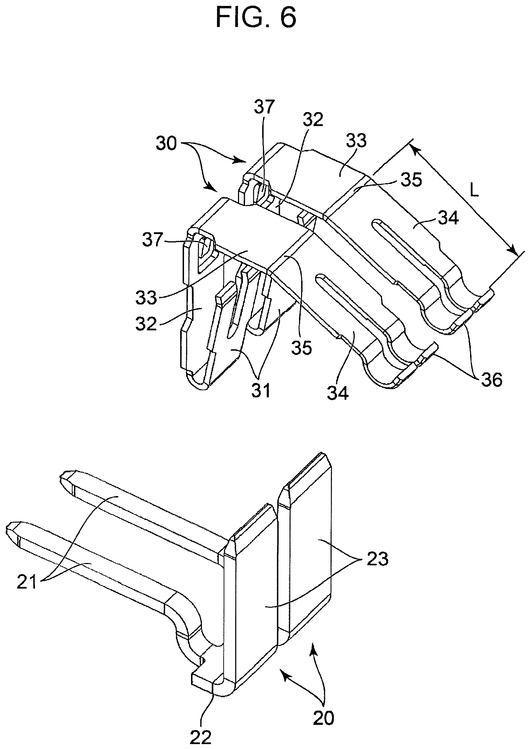

In the internal space 11 of the case 10, an opposing portion of the first contact surface 23a and second contact surface 16a is accommodation space for an elastic conductive plate 30. The elastic conductive plate 30 is formed from a leaf spring metal material such as stainless steel or beryllium copper. As indicated in Fig. 5 and Fig. 6, part of the elastic conductive plate 30 is bent in a V-shape, forming a first pressure contact portions 31 and a second pressure contact portions 32. The elastic conductive plate 30 is inserted into the case 10 while the bent portion between the first pressure contact portion 31 and the second pressure contact portion 32 faces downward. At that time, the second pressure contact portion 32 is downwardly inserted into the holding concave portion 16 formed in the peripheral wall support portion 15. Due to this, a pair of elastic conductive plates 30 is attached in the accommodation space. As for the elastic conductive plate 30, as indicated in Fig. 2, the first pressure contact portion 31 is elastically pressed against the first contact surface 23a and the second pressure contact portion 32 is elastically pressed against the second contact surface 16a. Since the first contact surface 23a is the front plate surface of the fixed conductive plate 20, the fixed conductive plate 20 and elastic conductive plate 30 are electrically continuous to each other on the first contact surface 23a.

As indicated in Fig. 5 and Fig. 6, a support piece portion 33, which is bent from the top of the second pressure contact portion 32 substantially at right angles, is integrally provided for each elastic conductive plate 30. As indicated in Fig. 5, a plurality (three) of support protrusion portions 13b protrude at the upper end of the inner wall portion 13 formed in the first case 10a so as to be spaced. An interval between adjacent support protrusion portions 13b is a restricting opposing portion 13c. As indicated in Fig. 4, the support piece portion 33 formed for each elastic conductive plate 30 is accommodated between adjacent support protrusion portions 13b. As for the elastic conductive plate 30, the second pressure contact portion 32 is held by the holding concave portion 16 and the support piece portion 33 is accommodated in a clearance between adjacent support protrusion portions 13b, so the elastic conductive plate 30 is firmly fixed in the second case 10b without, for example, being easily swung.

As indicated in Fig. 3 and Fig. 4, opposing concave portions 18 are formed in the lower surface of the second case 10b. When the second case 10b is fixed to the first case 10a, the upper portions of the support protrusion portions 13b enter the opposing concave portions 18. Therefore, the support piece portion 33 does not move beyond the support protrusion portions 13b at both sides of the support piece portion 33 toward the both side portions, and the support piece portion 33 is reliably held between the support protrusion portions 13b.

As for the elastic conductive plate 30, as indicated in Fig. 2, Fig. 5, and Fig. 6, a cut-and-raised piece 37 facing downward, which is cut and raised toward the left in the drawing, is formed in the second pressure contact portion 32. As indicated in Fig. 5, a fitting concave portion is formed in the second contact surface 16a on the inner side of the holding concave portion 16 in the first case 10a. The lower end in the fitting concave portion is a stopper step portion 16b. When the first pressure contact portion 31 of the elastic conductive plate 30 is downwardly inserted into the holding concave portion 16, the cut-and-raised piece 37 is fitted into the stopper step portion 16b, making it possible to determine a pressing position when the elastic conductive plate 30 is to be pressed into the first case 10a.

As for the lower surface of the second case 10b, as indicated in Fig. 2, a portion opposite to the support piece portion 33 is a restricting support portion 19. The restricting support portion 19 is opposite to the support piece portion 33 of the elastic conductive plate 30 from a side opposite to a side on which a fixed electrode portion 5 (circuit board 4) is provided. The support piece portion 33 is elastically pressed against the restricting support portion 19 by a reaction force resulting from an elastically-pressed contact point 36 being elastically pressed against the fixed electrode portion 5. Preferably, as indicated in Fig. 2, the restricting support portion 19 is in contact with the support piece portion 33 at a boundary portion 35 between the support piece portion 33 and an elastic arm portion 34 or in the vicinity of the boundary portion 35. Also, the restricting opposing portion 13c formed at the upper end of the inner wall portion 13 is opposite to the restricting support portion 19 with the support piece portion 33 intervening between them. Preferably, at the boundary portion 35 or in the vicinity of the boundary portion 35, the restricting opposing portion 13c is opposite to the front surface of the support piece portion 33, the front surface facing in the downward direction in the drawing, with a clearance left or is in contact with the front surface.

As indicated in Fig. 2, the support piece portion 33 is constrained from above and below by the restricting support portion 19 and restricting opposing portion 13c, and the cut-and-raised piece 37 is fitted to the stopper step portion 16b. Therefore, the upward and downward movement of the elastic conductive plate 30 in the case 10 is restricted. As for the elastic conductive plate 30, the second pressure contact portion 32 is held in the holding concave portion 16 indicated in Fig. 5, the support piece portion 33 is inserted between adjacent support protrusion portions 13b, and movement is restricted by the restricting support portion 19, restricting opposing portion 13c, and cut-and-raised piece 37. Due to these restricting structures, even if large acceleration is exerted from the outside, it is possible to reliably restrict the elastic conductive plate 30 from moving in the internal space 11 of the case 10.

As indicated in Fig. 1 and Fig. 2, the support piece portion 33 of the elastic conductive plate 30 passes through a clearance between the restricting support portion 19 and the restricting opposing portion 13c, passes the first contact surface 23a, and extends toward the interior of the internal space 11. The elastic arm portion 34 integrally extends from the support piece portion 33. The elastic arm portion 34 is bent downward with the boundary portion 35 between the support piece portion 33 and the elastic arm portion 34 taken as a bending portion, and the top of the elastic arm portion 34 is the elastically-pressed contact point 36, which is deformed in a concavely curved surface shape. The elastic arm portion 34 extends toward the fixed electrode portion 5 provided on the front surface of the circuit board 2, and the elastically-pressed contact point 36 is elastically pressed against the fixed electrode portion 5.

As for the fixed conductive plate 20 and elastic conductive plate 30, a gold-plated layer is formed at least on the front surface of a conductive contact portion. The gold-plated layer is formed on the front surface of a substrate layer such as nickel.

The electronic device 1 is mounted on the axle of a vehicle, its support portion, or the like, and the acceleration of the vehicle body is detected by an acceleration sensor mounted on the circuit board 2. Alternatively, various types of information may be detected by other physical quantity sensors. Detection signals of the acceleration sensor and the like undergo information processing by an IC or the like mounted on the circuit board 2. The elastically-pressed contact points 36 of a pair of elastic conductive plates 30 are each elastically pressed against the fixed electrode portion 5, and the signal that has undergone information processing is transmitted from a conductive pattern on the circuit board through the fixed electrode portion 5 to the elastic conductive plate 30. Furthermore, as for the elastic conductive plate 30, since the first pressure contact portion 31 is in contact with the contact plate portion 23 of the fixed conductive plate 20, the signal that has undergone information processing is given from the pair of elastic conductive plates 30 to a pair of fixed conductive plates 20. A plug is fitted into the connector portion 12 of the case 10.

In the electronic device 1, the support piece portion 33 of the elastic conductive plate 30 can be constrained from above and below by the restricting support portion 19 and restricting opposing portion 13c at a place close to the boundary portion 35. Since the elastically-pressed contact point 36 of the elastic conductive plate 30 is brought into pressure contact with the fixed electrode portion 5 on the circuit board 2, the support piece portion 33 is pressed in a direction away from the fixed electrode portion 5 due to the reaction force of the elastically-pressed contact point 36 and a portion of the support piece portion 33, the portion being in the vicinity of the boundary portion 35, is pressed against to the restricting support portion 19. As a result, with the boundary portion 35 taken as a base end (support end), it becomes possible to set the working length L of the elastic arm portion 34, which functions as a cantilever beam, with high dimensional precision as the length between the boundary portion 35 and the elastically-pressed contact point 36. Therefore, an elastic force between the elastically-pressed contact point 36 and the fixed electrode portion 5 can be appropriately set.

With the elastic conductive plate 30, a bending angle between the second pressure contact portion 32 and the support piece portion 33 is approximately 90 degrees. As indicated in Fig. 2, the bending angle θ of the elastic arm portion 34 from the support piece portion 33 is 90 degrees or less and is 45 degrees or less, and a 180-degree turn-back portion as described in PTL 1 is not provided. Therefore, it becomes possible to prevent large stress from concentrating on the base end (support end: that is, boundary portion 35) of the elastic arm portion 34.

### Reference Signs List

- 1: electronic device
- 2: circuit board
- 5: fixed electrode portion
- 10: case
- 10a: first case
- 10b: second case
- 11: internal space
- 13: inner wall portion
- 13b: support protrusion portion
- 13c: restricting opposing portion
- 16: holding concave portion
- 16a: second contact surface
- 19: restricting support portion
- 20: fixed electrode plate
- 21: external terminal portion
- 23: contact plate portion
- 23a: first contact surface
- 30: elastic conductive plate
- 31: first pressure contact portion
- 32: second pressure contact portion
- 33: support piece portion
- 34: elastic arm portion
- 35: boundary portion
- 36: elastically-pressed contact point
- 37: cut-and-raised piece

## Claims

1. An electronic device (1), having a fixed conductive plate (20) and an elastic conductive plate (30), in which the fixed conductive plate (20), part of which becomes an external terminal portion (21), the elastic conductive plate (30) connected to the fixed conductive plate (20), and a fixed electrode portion (5) that is electrically continuous to the elastic conductive plate (30) are provided in a case (10), the electronic device (1) being **characterized in that**:
a first contact surface (23a) and a second contact surface (16a), which are opposite to each other, are provided in the case (10), at least one of the first contact surface (23a) and the second contact surface (16a) being a front plate surface of the fixed conductive plate (20);
as for the elastic conductive plate (30), a first pressure contact portion (31), which is elastically pressed against the first contact surface (23a), a second pressure contact portion (32), which is turned-backed from the first pressure contact portion (31) and is elastically pressed against the second contact surface (16a), a support piece portion (33), which is bent from the second pressure contact portion (32) and extends beyond the first contact surface (23a), an elastic arm portion (34), which is bent from the support piece portion (33) and extends toward the fixed electrode portion (5), and an elastically-pressed contact point (36), which is provided at a top of the elastic arm portion (34) and is elastically pressed against the fixed electrode portion (5), are integrally formed from a leaf spring metal material;
at least one of the first pressure contact portion (31) and the second pressure contact portion (32) is in contact with the front plate surface of the fixed conductive plate (20); and
a restricting support portion (19) positioned on a side opposite to the fixed electrode portion (5) with the elastic conductive plate (30) interposed between the restricting support portion (19) and the fixed electrode portion (5) is provided, the restricting support portion (19) restricting travel of the support piece portion (33) in a direction away from the fixed electrode portion (5).

2. The electronic device (1) having the fixed conductive plate (20) and elastic conductive plate (30) according to Claim 1, wherein a restricting opposing portion (13c) is provided, the restricting opposing portion (13c) being opposite to the restricting support portion (19) with the support piece portion (33) interposed between the restricting opposing portion (13c) and the restricting support portion (19) or being in contact with the support piece portion (33).

3. The electronic device (1) having the fixed conductive plate (20) and elastic conductive plate (30) according to Claim 2, wherein the restricting support portion (19) and the restricting opposing portion (13c) are opposite to a position close to a boundary portion (35) of the support piece portion (33) with the elastic arm portion (34) .

4. The electronic device (1) having the fixed conductive plate (20) and elastic conductive plate (30) according to 2 or 3, wherein: an inner wall portion (13) is provided in the case (10); a plurality of support protrusion portions (13b) are provided at a top of the inner wall; and the restricting opposing portion (13c) is provided between adjacent support protrusion portions (13b).

5. The electronic device (1) having the fixed conductive plate (20) and elastic conductive plate (30) according to Claim 4, wherein: an opposing concave portion (18) is formed in the case (10), the support protrusion portion (13b) being opposite to the opposing concave portion (18); and a top of the support protrusion portion (13b) is inserted into the opposing concave portion (18).

## Patentansprüche

1. Elektronische Vorrichtung (1) mit einer feststehenden leitfähigen Platte (20) und einer elastischen leitfähigen Platte (30), wobei die feststehende leitfähi - ge Platte (20), von der ein Teil zu einem externen Anschlussbereich (21) wird, die mit der feststehenden leitfähigen Platte (20) verbundene elasti - sehe leitfähige Platte (30) und ein feststehender Elektrodenbereich (5), der zu der elastischen leitfähigen Platte (30) elektrisch kontinuierlich ist, in ei - nem Gehäuse (10) angeordnet sind,
wobei die elektronische Vorrichtung (1) **dadurch gekennzeichnet ist, dass**:
eine erste Kontaktfläche (23a) und eine zweite Kontaktfläche (16a), die ein - ander gegenüberliegen, in dem Gehäuse (10) vorgesehen sind, wobei min - destens eine von der ersten Kontaktfläche (23a) und der zweiten Kontakt - fläche (16a) eine vordere Plattenoberfläche der feststehenden leitfähigen Platte (20) ist;
bei der ersten leitfähigen Platte (30) ein erster Druckkontaktbereich (31), der elastisch gegen die erste Kontaktfläche (23a) gedrückt ist, ein zweiter Druckkontaktbereich (32), der von dem ersten Druckkontaktbereich (31) nach hinten umgebogen ist und elastisch gegen die zweite Kontaktfläche (16a) gedrückt ist, ein Stützteilbereich (33), der von dem zweiten Druckkontaktbereich (32) umgebogen ist und sich über die erste Kontaktfläche (23) hinaus erstreckt, ein elastischer Armbereich (34), der von dem Stützteilbe - reich (33) umgebogen ist und sich in Richtung auf den feststehenden Elektrodenbereich (5) erstreckt, und ein elastisch mit Druck beaufschlagter Kon - taktpunkt (36), der auf einer Oberseite des elastischen Armbereichs (34) vorgesehen ist und elastisch gegen den feststehenden Elektrodenbereich (5) gedrückt ist, in integraler Weise aus einem Blattfeder-Metallmaterial gebildet sind;
mindestens einer von dem ersten Druckkontaktbereich (31) und dem zwei - ten Druckkontaktbereich (32) mit der vorderen Plattenoberfläche der festste - henden leitfähigen Platte (20) in Kontakt steht; und
ein einschränkender Stützbereich (19) vorhanden ist, der auf einer dem feststehenden Elektrodenbereich (5) gegenüberliegenden Seite positioniert ist, wobei die elastische leitfähige Platte (30) zwischen dem einschränken - den Stützbereich (19) und dem feststehenden Elektrodenbereich (5) ange - ordnet ist, wobei der einschränkende Stützbereich (19) die Bewegung des Stützteilbereichs (33) in Richtung von dem feststehenden Elektroden bereich (5) weg einschränkt.

2. Elektronische Vorrichtung (1) mit der feststehenden leitfähigen Platte (20) und der elastischen leitfähigen Platte (30) nach Anspruch 1,
wobei ein einschränkender gegenüberliegender Bereich (13c) vorhanden ist, wobei der einschränkende gegenüberliegende Bereich (13c) dem ein - schränkenden Stützbereich (19) gegenüberliegt, wobei der Stützteilbereich (33) zwischen dem einschränkenden gegenüberliegenden Bereich (13c) und dem einschränkenden Stützbereich (19) angeordnet ist oder mit dem Stützteilbereich (33) in Kontakt steht.

3. Elektronische Vorrichtung (1) mit der feststehenden leitfähigen Platte (20) und der elastischen leitfähigen Platte (30) nach Anspruch 2,
wobei der einschränkende Stützbereich (19) und der einschränkende ge - genüberliegende Bereich (13c) gegenüber einer Position nahe einem Grenzbereich (35) des Stützteilbereichs (33) mit dem elastischen Armbereich (34) angeordnet sind.

4. Elektronische Vorrichtung (1) mit der feststehenden leitfähigen Platte (20) und der elastischen leitfähigen Platte (30) nach Anspruch 2 oder 3, wobei:
ein Innenwandbereich (13) in dem Gehäuse (10) vorgesehen ist;
eine Mehrzahl von Stützvorsprungbereichen (13b) an einer Oberseite der Innenwand vorgesehen sind; und
der einschränkende gegenüberliegende Bereich (13c) zwischen benachbarten Stützvorsprungbereichen (13b) vorgesehen ist.

5. Elektronische Vorrichtung (1) mit der feststehenden leitfähigen Platte (20) und der elastischen leitfähigen Platte (30) nach Anspruch 4, wobei:
ein gegenüberliegender konkaver Bereich (18) in dem Gehäuse (10) ausge - bildet ist,
der Stützvorsprungbereich (13b) gegenüber dem gegenüberliegenden kon - kaven Bereich (18) angeordnet ist; und
eine Oberseite des Stützvorsprungbereichs (13b) in den gegenüberliegenden konkaven Bereich (18) eingesetzt ist.

## Revendications

1. Dispositif électronique (1) ayant une plaque conductrice fixe (20) et une plaque conductrice élastique (30), dans lequel la plaque conductrice fixe (20), dont une partie devient une partie terminale externe (21), la plaque conductrice élastique (30) reliée à la plaque conductrice fixe (20), ainsi qu'une partie d'électrode fixe (5) présentant une continuité électrique avec la plaque conductrice élastique (30) sont situées dans un boîtier (10), le dispositif électronique (1) étant **caractérisé en ce que** :
une première surface de contact (23a) et une deuxième surface de contact (16a), qui sont à l'opposé l'une de l'autre, sont situées dans le boîtier (10), au moins l'une de la première surface de contact (23a) et de la deuxième surface de contact (16a) étant une surface de plaque avant de la plaque conductrice fixe (20) ;
en ce qui concerne la plaque conductrice élastique (30), une première partie de contact par pression (31), qui est pressée de manière élastique contre la première surface de contact (23a), une deuxième partie de contact par pression (32), qui est retournée par rapport à la première partie de contact par pression (31) et pressée de manière élastique contre la deuxième surface de contact (16a), une partie pièce de support (33), qui est pliée à partir de la deuxième partie de contact par pression (32) et qui s'étend au-delà de la première surface de contact (23a), une partie de bras élastique (34), qui est pliée à partir de la partie pièce de support (33) et qui s'étend vers la partie d'électrode fixe (5), et un point de contact pressé de manière élastique (36),
qui se situe en haut de la partie de bras élastique (34) et qui est pressé de manière élastique contre la partie d'électrode fixe (5), sont intégralement formés à partir d'une feuille de matériau métallique à ressort ;
au moins l'une de la première partie de contact par pression (31) et de la deuxième partie de contact par pression (32) est en contact avec la surface de plaque avant de la plaque conductrice fixe (20) ; et
une partie de support limitante (19), positionnée sur un côté opposé à la partie d'électrode fixe (5) avec la plaque conductrice élastique (30) interposée entre la partie de support limitante (19) et la partie d'électrode fixe (5), est fournie, la partie de support limitante (19) limitant le mouvement de la partie pièce de support (33) dans une direction s'éloignant de la partie d'électrode fixe (5).

2. Le dispositif électronique (1) ayant une plaque conductrice fixe (20) et une plaque conductrice élastique (30) selon la revendication 1, dans lequel une partie opposée limitante (13c) est fournie, la partie opposée limitante (13c) étant opposée à la partie de support limitante (19) avec la partie pièce de support (33) interposée entre la partie opposée limitante (13c) et la partie de support limitante (19), ou étant en contact avec la partie pièce de support (33).

3. Le dispositif électronique (1) ayant une plaque conductrice fixe (20) et une plaque conductrice élastique (30) selon la revendication 2, dans lequel la partie de support limitante (19) et la partie opposée limitante (13c) sont opposées à une position près d'une partie limite (35) de la partie pièce de support (33) avec la partie de bras élastique (34).

4. Le dispositif électronique (1) ayant une plaque conductrice fixe (20) et une plaque conductrice élastique (30) selon la revendication 2 ou 3, dans lequel : une partie de paroi intérieure (13) est située dans le boîtier (10) ; une pluralité de parties de protubérance de support (13b) sont situées en haut de la paroi intérieure ; et la partie opposée limitante (13c) est située entre des parties de protubérance de support (13b) adjacentes.

5. Le dispositif électronique (1) ayant une plaque conductrice fixe (20) et une plaque conductrice élastique (30) selon la revendication 4, dans lequel : une partie concave opposée (18) est formée dans le boîtier (10), la partie de protubérance de support (13b) étant opposée à la partie concave opposée (18) ; et un sommet de la partie de protubérance de support (13b) est inséré dans la partie concave opposée (18).
